# FASCICULE DE BREVET EUROPEEN

(11) **EP 2 727 144 B1**
(45) Date de publication et mention de la délivrance du brevet: **05.08.2020**
(21) Numéro de dépôt: 12734993.4
(22) Date de dépôt: 26.06.2012
(51) Int. Cl.: H01L 21/60, H01L 23/485, H01L 25/00

(54) **PROCÉDÉ D'HYBRIDATION D'UN COMPOSANT MUNI D'INSERTS CREUX**
VERBINDUNGSVERFAHREN FÜR EINEN BAUTEIL MIT HOHLEN EINSÄTZEN
METHOD FOR CONNECTING A COMPONENT EQUIPPED WITH HOLLOW INSERTS

(30) Priorité: 30.06.2011 FR 1155916
(43) Date de publication de la demande: 07.05.2014
(73) Titulaire: Commissariat à l'Énergie Atomique et aux Énergies Alternatives, 75015 Paris (FR)
(72) Inventeur: MARION, François, 38950 Saint Martin le Vinoux (FR)
(74) Mandataire: Cabinet Laurent & Charras
(86) Numéro de dépôt international: PCT/FR2012/051460
(87) Numéro de publication internationale: WO 2013/001225

(56) Documents cités:
- FR-A1- 2 928 033
- FR-A1- 2 936 359
- JP-A- 4 010 446

## Description

### DOMAINE DE L'INVENTION

L'invention a trait au domaine de la connexion de deux composants selon la technique d'hybridation face contre face, mieux connue sous l'expression anglo-saxonne «*flip chip*»*,* et plus particulièrement la connexion de deux composants électroniques par insertion à température ambiante du type métal d'inserts dans un métal constitutif de plots.

L'invention trouve ainsi particulièrement application dans les assemblages dits « puce sur puce », « puce sur wafer » et « wafer sur wafer ».

### ETAT DE LA TECHNIQUE

Pour remplacer les hybridations «*flip chip*» par billes de soudure, il est connu de prévoir sur une face d'un premier composant électronique des inserts réalisés en un métal dur, par exemple en nitrure de titane, et sur une face d'un deuxième composant électronique des plots réalisé en un métal ductile, par exemple en argent, puis d'hybrider les deux composants en insérant à froid les inserts dans les plots, ce qui crée ainsi des interconnexions mécaniques et électriques entre les composants.

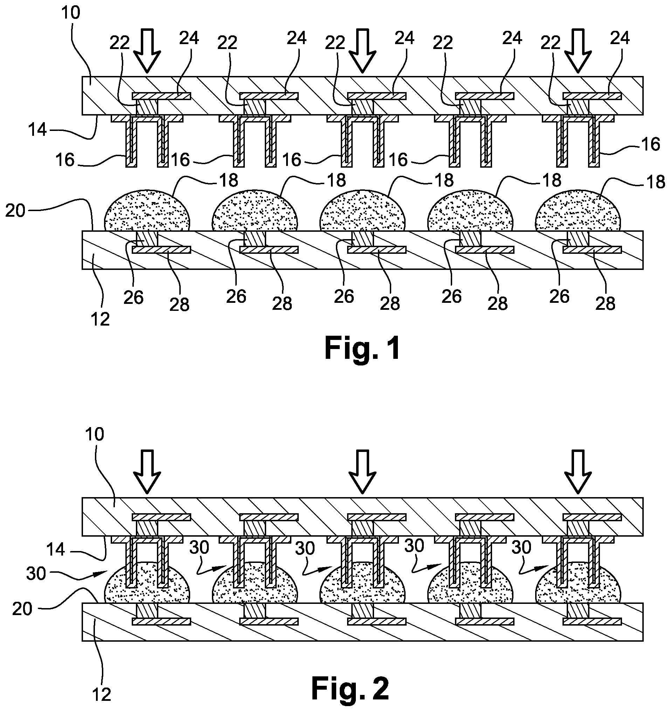

Les figures 1 et 2 illustrent de manière schématique, l'hybridation «*flip-chip*» d'un premier et d'un second composants microélectroniques **10, 12.** Le premier composant **10** comporte sur l'une de ses faces **14,** un ensemble d'inserts **16** électriquement conducteurs, destinés à pénétrer dans des plots **18** électriquement conducteurs respectifs, les plots **18** étant agencés sur la face **20** du second composant **12.**

Le fond de chaque insert **16** est par ailleurs au contact d'une plage de connexion **22** formée dans l'épaisseur du premier composant **10,** cette plage **22** faisant l'interface avec par exemple avec un circuit électronique **24.** De manière analogue, chaque plot **18** est au contact d'une plage de connexion **26** formée dans l'épaisseur du second composant **12,** la plage **26** faisant l'interface par exemple avec un circuit électronique **28.**

Pour réaliser l'hybridation, préférentiellement à froid, les composants électroniques **10** et **12** sont alignés de manière à présenter chaque insert **16** en face d'un plot **18,** et une pression appropriée, illustrée par les flèches, est par exemple exercée sur le premier composant qui est mobile (figure 1). Les inserts **16,** qui ont une dureté supérieure à celle des plots **18,** pénètrent alors dans ceux-ci. Des interconnexions **30** entre le premier et les second composants microélectroniques **10, 12** sont ainsi réalisées (figure 2). Les interconnexions **30** solidarisent mécaniquement les deux composants **10, 12,** tout en créant des connexions électriques entre ceux-ci.

A titre d'exemple, le premier composant **10** est une matrice de détection constituée d'une pluralité d'éléments sensibles de détection, notamment de rayonnement électromagnétique, et le second composant **12** est un circuit de lecture desdits éléments sensibles. Les interconnexions **30** réalisent ainsi la connexion électrique du circuit de lecture avec chacun des éléments sensibles du premier composant **10.**

Toutefois, un problème récurrent dans ce type d'hybridation par insertion « métal dans métal » réside dans le fait que, sans opération particulière, la surface des inserts s'oxyde, ce qui crée des connexions électriques de mauvaise qualité entre les inserts et les plots dans lesquels ils sont enfichés. En effet, les métaux adaptés pour une insertion à froid, plus communément les métaux « durs », comme par exemple le nitrure de titane, sont oxydables.

Une solution utilisée pour éviter l'insertion d'inserts oxydés est de fabriquer des inserts **16** constitués chacun d'une âme centrale en métal présentant une dureté supérieure à celle des plots **18,** et de recouvrir cette âme, avant son oxydation, d'une couche de métal noble, et donc non oxydable, comme de l'or ou du platine. L'âme et la couche de métal noble sont ainsi insérées ensemble dans un plot **18** sans qu'il y ait apparition d'oxyde susceptible d'affecter la qualité de la connexion électrique.

Un exemple de procédé de fabrication à bas coût d'inserts **16** cylindriques creux recouverts d'une couche de métal noble est décrit ci-dessous en relation avec les figures schématiques en coupe 3 à 10.

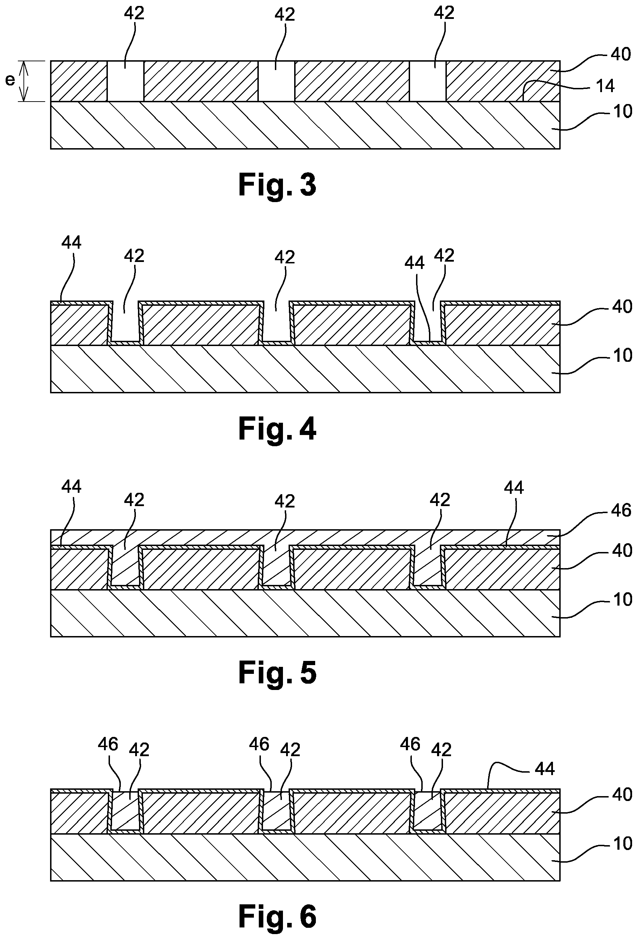

Le procédé débute par le dépôt d'une couche sacrificielle **40** d'une épaisseur *e* sur la face **14** du composant **10,** par exemple une couche de résine du type polyimide, suivi d'une photolithographie pour réaliser des trous circulaires **42** dans la couche sacrificielle **40** jusqu'à la face **14** du composant **10** (figure 3). L'épaisseur *e* correspond à la hauteur désirée pour l'âme des inserts et le diamètre des trous circulaires **42** correspond au diamètre extérieur de l'âme.

Le procédé se poursuit par le dépôt pleine plaque d'une couche ou d'un multicouche de métal dur **44,** par exemple du nitrure de titane ou un alliage à base de nitrure de titane, d'une épaisseur correspondant à l'épaisseur de l'âme des inserts **16.** Le dépôt est par exemple un dépôt chimique en phase vapeur, ou dépôt « CVD » (pour l'acronyme anglo-saxon « *Chemical Vapor Déposition* ») réalisé à une température compatible avec les éléments microélectroniques du composant **10,** notamment une température inférieure à 425°C pour un composant **10** mettant en œuvre une technologie CMOS (figure 4).

Un retrait de la portion de la couche de métal dur **44** déposée entre les trous **42** est alors effectué, par exemple à l'aide d'une gravure « damascène » ou de « gap fil » bien connu en soi.

Par exemple, selon la gravure « gap-fil », une couche de résine fluide **46** est déposée pleine plaque et vient ainsi combler les trous **42** et planariser l'ensemble obtenu à l'étape précédente (figure 5). Une fois solidifiée, la couche de résine **46** est alors gravée uniformément, par exemple par un polissage mécanique ou mécanochimique, jusqu'à atteindre la surface de couche métallique **46.** Les trous **42** restent quant à eux remplis de résine **46** afin de protéger le métal les recouvrant lors des étapes ultérieures (figure 6). Une gravure du métal **44** agencé entre les trous **42** est alors mise en œuvre de manière connue en soi (figure 7).

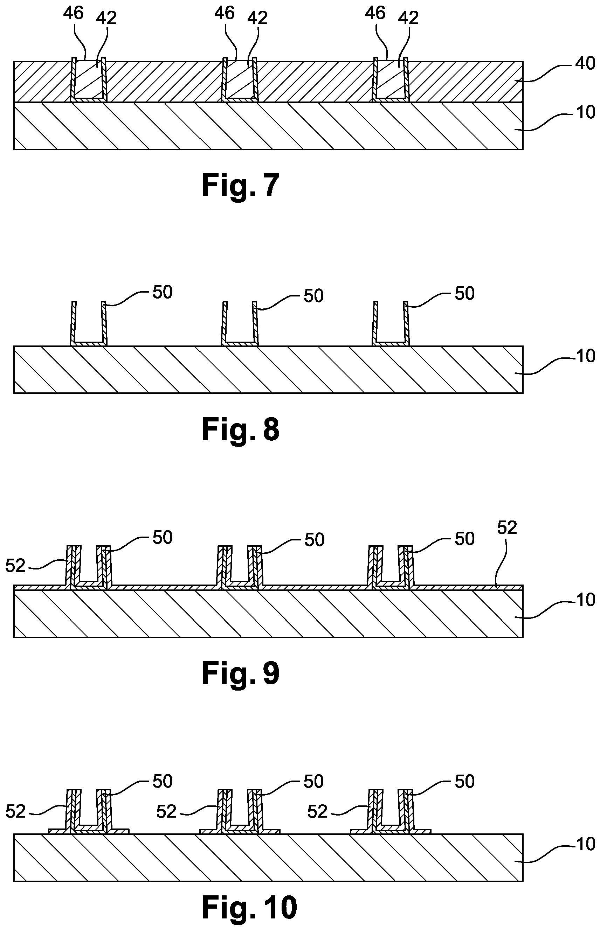

Le procédé se poursuit alors par le retrait de la résine **46** comprise dans les trous **42,** par exemple à l'aide d'un délaquage à base d'un plasma O₂ suivi du retrait de la couche sacrificielle **40,** par exemple au moyen d'un délaquage à base d'un plasma O₂ (figure 8). Les âmes **50** des inserts **16** sont ainsi réalisées.

Une couche **52** en métal noble est ensuite déposée pleine plaque, tel qu'une couche d'or ou de platine, par exemple au moyen d'un dépôt CVD (figure 9), puis la portion de couche **52** agencée entre les âmes **50** est ôtée, par exemple au moyen de la technique de photolithographie classique (figure 10).

Cependant, ce procédé présente un certain nombre d'inconvénients. Tout d'abord, même si le procédé s'avère de « bas coût » et permet un rendement de fabrication élevé, il met en œuvre des étapes complexes et nombreuses.

Ensuite, ce type de procédé implique une difficulté, voire une impossibilité, de réduire les pas d'interconnexion, c'est-à-dire l'espace minimal entre deux interconnexions inserts/plots, si des techniques de fabrication à bas coût de la couche de métal noble recouvrant les âmes métalliques des inserts sont utilisées. En effet les techniques de fabrication à bas coût consistent à réaliser un dépôt pleine plaque d'une couche de métal noble sur la face du composant comportant les inserts, puis à graver ensuite la couche de métal noble présente entre les inserts. Or, la seule technique de gravure à bas coût de l'état de la technique applicable aux métaux nobles comme l'or et le platine est une gravure chimique en phase liquide qui ne permet pas à l'heure actuelle de graver des surfaces de dimensions inférieures à 10 micromètres, voire 15 micromètres. Seule une gravure par usinage ionique permet aujourd'hui de graver des pas d'interconnexion inférieurs à 10 micromètres. Cependant, cette technique présente un rendement très faible en raison notamment des nettoyages nécessaires entre chaque dépôt, et s'avère donc onéreuse.

Cette difficulté de réduction du pas d'interconnexion est illustrée aux figures schématiques en coupe 11 et 12.

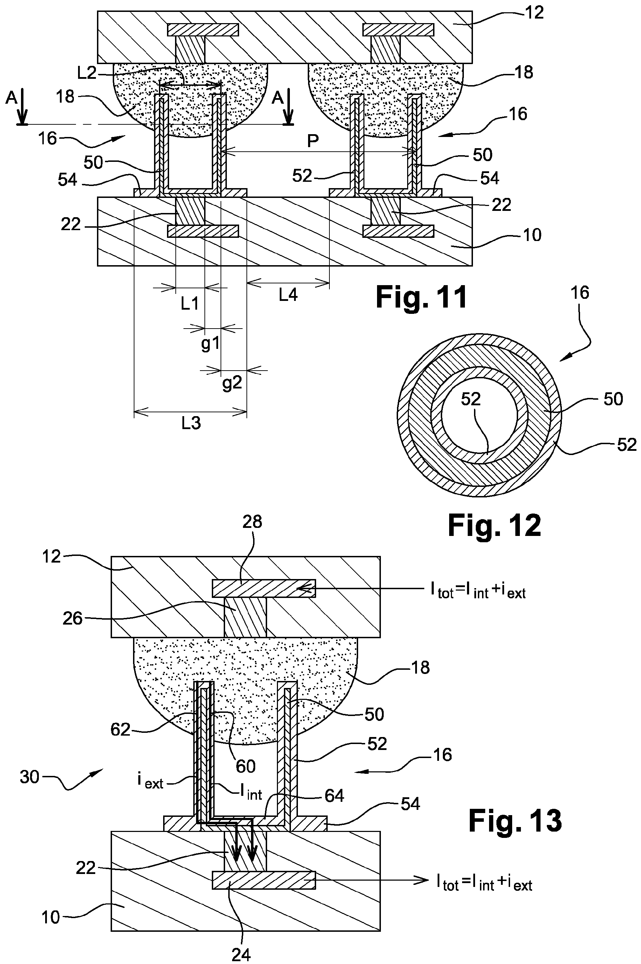

Notamment, comme cela est visible sur la figure 11, la couche de métal noble **52** n'est pas entièrement retirée entre les inserts **16** en raison de la précision de la gravure en phase liquide utilisée. Il demeure ainsi une couronne de métal noble **54** autour de chaque insert **16.**

En prenant l'hypothèse simplificatrice de plages de connexion cylindrique 22 alignées avec leurs inserts **16** respectifs, le pas d'interconnexion minimum *P* est égal à la somme de la largeur *L1* de la plage de connexion **22,** du double de la largeur *G1* entre le diamètre externe de l'âme **50** d'un insert **16** et le bord de la plage de connexion **22,** du double de la largeur *G2* entre le diamètre externe de l'âme **50** et le bord de la couronne **54** entourant un insert **16,** et de la largeur *L4* séparant deux couronnes **54** d'inserts **16** adjacents, à savoir P = L1 + 2G1 + 2G2 + L4.

La largeur *L1* est principalement fixée par le courant maximal destiné à traverser l'interconnexion **30** formée d'un insert **16** inséré dans un plot **18** et est donc sensiblement indépendante du procédé de fabrication des inserts **16.** Une largeur *L1* minimale, par exemple dans les imageurs, est de 3 micromètres.

La largeur *G1* dépend quant à elle de la précision de la photolithogravure utilisée pour réaliser les ouvertures **42** dans la couche sacrificielle **40.** A l'aide des techniques de gravure actuelles, la largeur *G1* minimale réalisable est d'environ 1 micromètre.

Les largeurs *G2* dépend de la précision de la photolithogravure utilisée pour ôter la couche de métal noble **52** entre les inserts **16.** A l'aide des gravures actuelles, la largeur G2 minimale réalisable est d'environ 1 micromètre.

Enfin, la largeur *L4* représente également la distance séparant deux éléments conducteurs d'interconnexion **30** adjacents. On estime qu'une largeur minimale *L4* d'environ 3 micromètres est appropriée pour éviter tout risque de court circuit entre les interconnexions.

En outre, les métaux nobles, par exemple l'or ou le platine, sont très réfléchissants, ce qui gêne la photolithogravure. Par ailleurs, les chimies de gravure sont très agressives pour les circuits, notamment les capteurs d'image.

Ainsi donc, le pas d'interconnexion *P* minimal réalisable est à l'heure actuelle d'environ 10 micromètres, soit une densité surfacique d'interconnexions égale à environ 10⁴ interconnexions/mm².

Les documents FR 2 928 033 et FR 2 936 359 divulguent des inserts du type précité et des procédés de fabrication et d'hybridation correspondants .

### EXPOSE DE L'INVENTION

Le but de la présente invention est de proposer des inserts permettant de réduire le pas d'interconnexion et qui soient réalisables avec les techniques de fabrication usuelles, ainsi qu'un procédé bas coût de fabrication de tels inserts, et notamment un procédé permettant également la réalisation d'une hybridation de microcomposants à température ambiante.

A cet effet, l'invention a pour objet un procédé d'hybridation défini dans les revendications 1 et 7 et comportant un composant de connexion électro-mécanique muni sur une face de connexion d'inserts conducteurs destinés à être insérés à température ambiante dans des plots conducteurs ductiles respectifs ménagés sur une face d'un autre composant de connexion pour une hybridation du type face contre face.

Selon l'invention :
▪ le procédé comprend pour chaque insert :
   ∘ une âme métallique creuse constituée d'un fond disposé sur la face de connexion et d'une paroi latérale faisant saillie dudit fond, définissant une surface interne de l'insert, au moins une portion de ladite surface interne étant non oxydée; et
   ∘ une couche métallique recouvrant sensiblement uniquement la surface interne de l'âme métallique et destinée à être au contact du plot associé à l'insert ;
▪ et la couche métallique est constituée d'un métal inoxydable, notamment un métal noble ou la réalisation de la couche métallique comporte :
   ∘ la réalisation d'une première sous-couche métallique non oxydée sur au moins une portion de sa surface, recouvrant au moins ladite portion non oxydée de la surface interne de l'âme, la première sous-couche ayant une plasticité supérieure à celle de l'âme ; et
   ∘ la réalisation d'une seconde sous-couche recouvrant au moins la première sous-couche sur sa portion non oxydée et ayant une plasticité inférieure à celle de la première sous-couche.

Par « température ambiante », on entend ici une température éloignée de la température de fusion du matériau constitutif de la première couche et des plots, par exemple des températures de l'ordre de 300°K, pour lesquels on n'observe donc pas un ramollissement important de cette première couche et des plots dans lesquels sont destinés à être insérer les inserts. L'hybridation « à froid », ou « à température ambiante » de l'invention se distingue donc des hybridations de type « thermo-compression » au cours desquelles à la fois une pression et un chauffage sont exercés, le chauffage ayant pour but de ramollir ou fondre les plots afin de faciliter l'insertion des inserts.

En d'autres termes, il est choisi de ne pas recouvrir entièrement l'âme centrale métallique des inserts mais uniquement sa partie creuse, et donc de ne pas prendre de mesure particulière pour éviter l'oxydation de la surface externe de l'âme centrale. En évitant de recouvrir la surface externe de l'âme d'une couche de métal noble, on s'affranchit donc corolairement de la présence d'une couronne de métal noble autour des inserts.

C'est en effet en cherchant à protéger l'intégralité de la surface oxydable de l'âme centrale en mettant en œuvre des procédés de fabrication bas coût, et notamment un dépôt pleine plaque, qu'une couche métallique indésirable est déposée entre les inserts, couche indésirable qu'il faut ensuite retirer à l'aide de gravure bas coût à la précision limitée. Ainsi des couronnes métalliques autour des inserts sont inévitablement réalisées, ce qui limite la minimisation du pas d'interconnexion.

Il est remarquable que la plus grande surface conductrice a jusqu'ici été recherchée pour un insert afin de maximiser la qualité de l'interconnexion électrique formée d'un insert et d'un plot. C'est notamment ce qui motive de recouvrir entièrement l'âme conductrice centrale d'une couche de métal noble afin que la totalité de la surface de l'âme ne soit pas oxydée. Cette motivation implique donc, dans le cadre d'un procédé de fabrication à bas coût, de dégager l'âme centrale des inserts de la couche sacrificielle dans laquelle elle est réalisée pour procéder à un dépôt pleine plaque, de manière à enrober totalement cette âme d'une couche de métal noble.

Toutefois, les inventeurs ont remarqué que cette démarche se fonde en fait sur un présupposé techniquement erroné, à savoir que la surface externe et la surface interne de l'âme définissent des chemins conducteurs d'électricité d'importances analogues.

En fait, les métaux nobles, et plus généralement les métaux non oxydables, ont une résistivité électrique inférieure à celle des métaux durs utilisés pour réaliser l'âme centrale. Ainsi donc, le courant emprunte préférentiellement la couche de métal noble plutôt que l'âme centrale.

En se référant à la figure schématique en coupe 13, lorsqu'un courant total *Iₜₒₜ* circule dans une interconnexion **30,** par exemple un courant injecté via la plage **26** du plot **18,** ce courant total *Iₜₒₜ* se décompose en un premier courant *Iᵢₙₜ* circulant dans la portion interne **60** de la couche de métal noble **52** et en un second courant *iₑₓₜ* circulant dans la portion externe **62** de la couche **52.** Or, comme cela est visible, le courant externe *iₑₓₜ* doit traverser deux fois l'âme centrale **50,** qui est de résistivité supérieure à celle de la couche **52,** pour atteindre la plage de connexion **22** de l'insert **16.** En revanche, le courant interne *Iᵢₙₜ* ne traverse qu'une fois l'âme centrale au niveau du fond **64** de celle-ci. Des mesures montrent ainsi que le courant interne *Iᵢₙₜ* représente 90% du courant total *Iₜₒₜ* et donc que le courant externe *iₑₓₜ* ne représente que 10% de ce courant.

Aussi, la portion externe **62** de la couche de métal noble **52** peut être considérée comme un bras mort réalisant une conduction électrique négligeable et son élimination n'entraine pas une dégradation sensible de la conduction électrique d'une interconnexion **30.**

En outre, selon une première variante, la couche métallique étant constituée d'un métal inoxydable, notamment un métal noble, tel que de l'or ou du platine, ceci permet donc de définir une surface non-oxydée en interface avec le plot lorsque l'insert est inséré dans le plot.

Cependant, cette variante présente un certain nombre d'inconvénients, au rang desquels :
▪ un coût élevé, d'une part, en raison du coût des métaux nobles et, d'autre part, en raison des étapes complexes et nombreuses à mettre en œuvre pour recouvrir uniquement les inserts d'une couche d'un tel métal ;
▪ une impossibilité de réduire les pas d'interconnexion, comme précédemment décrit en raison de la précision limitée des gravures en phase liquide des métaux nobles ;
▪ une inter-diffusion et une électro-migration du métal noble recouvrant les inserts. Ainsi les interconnexions finissent par être constituées d'un multicouche complexe formé du matériau des inserts, du métal noble et du matériau des plots, ce qui rend les interconnexions très sensibles à la diffusion du type solide/solide, à la création de trous de type Kirkendall, et de trous aux interfaces des zones constituées de métaux différents ; et
▪ une contamination croisée de l'or. En effet, l'or est un matériau très dopant pour le silicium usuellement présent dans les composants électroniques. Toutes les étapes de fabrication utilisant de l'or doivent donc être réalisées dans des zones de fabrication différentes de celles où du silicium est présent à nu.

La seconde variante multicouche permet une hybridation «*flip chip*» par insertion d'inserts métalliques dans des plots métalliques assurant une connexion électrique sans utilisation de métaux nobles.

Sous l'effet de l'insertion dans un plot, les différentes régions d'un insert subissent une déformation. Ayant une plasticité supérieure à celle de l'âme, la première sous-couche va donc subir une plus forte déformation que celle-ci lors de la pénétration dans un plot. Comme par ailleurs la seconde sous-couche a une plasticité inférieure à celle de la première sous-couche, cette seconde sous-couche ne peut se déformer autant que la première sous-couche sans casser. Ne pouvant se conformer à la déformation subie par la première sous-couche, la seconde sous-couche se « craquelle ».

Si l'adhérence de la seconde sous-couche sur la première sous-couche est faible, la seconde sous-couche « pèle » en glissant sur la première sous-couche lors de l'insertion et demeure à l'extérieur du plot, découvrant alors entièrement la première sous-couche qui est non oxydée et donc bonne conductrice d'électricité.

Si l'adhérence de la seconde sous-couche sur la première sous-couche est forte, la seconde sous-couche pénètre également dans le plot tout en présentant des craquelures en raison du différentiel de plasticité avec la première sous-couche. Les craquelures définissent ainsi autant de « chemins » électriques non oxydés vers la première sous-couche non oxydée, et donc bons conducteurs d'électricité, assurant ainsi une bonne conduction électrique de l'interconnexion formée de l'insert et du plot.

Ce résultat est obtenu indépendamment de la nature oxydable de la première sous-couche qui est donc choisie avantageusement parmi des matériaux non nobles. Il n'est pas non plus nécessaire d'utiliser un flux désoxydant lors de l'insertion puisque les chemins électriques sont formés, et cela même si la seconde sous-couche est oxydée.

Selon un mode de réalisation, l'adhérence de la seconde sous-couche sur la première sous-couche est faible de manière à ce que la seconde sous-couche glisse sur la première sous-couche sous l'effet d'un cisaillement appliqué à l'empilement des première et seconde sous-couches. De cette manière, lors de l'insertion de l'insert dans un plot, la seconde sous-couche pèle et demeure à l'extérieur du plot.

Selon un mode de réalisation, la première sous-couche est constituée d'un métal oxydable, et la seconde sous-couche est réalisée en oxydant la première sous-couche de manière à créer une couche d'oxyde natif du métal de la première sous-couche ayant une plasticité inférieure à celle de la première sous-couche

Par « couche d'oxyde natif », on entend une couche d'oxyde obtenue par l'oxydation naturelle du métal lorsqu'il est au contact avec l'oxygène.

La couche d'oxyde natif présente la double propriété d'être très cassante et de très peu adhérer au métal dont elle est issu. Sous l'effet de la pénétration de l'insert dans le plot, on observe ainsi un phénomène de « *ice on mud* », c'est-à-dire que la couche d'oxyde natif se craquelle en forme de plaques qui glissent sur la première sous-couche lors de l'insertion. La seconde sous-couche est donc « pelée » et reste à l'extérieur du plot.

En outre, la couche d'oxyde natif a l'avantage de présenter une épaisseur très fine, de l'ordre de quelques nanomètres, complètement définie par la nature du métal. Ainsi quel que soit le temps d'exposition de la première sous-couche à l'oxygène, l'épaisseur de la seconde sous-couche reste constante.

De plus, le composant électronique pourvu d'inserts peut donc être stocké dans des conditions oxydantes, comme l'air par exemple, sans précaution particulière.

Ainsi donc, non seulement, la première sous-couche n'est pas un métal noble mais en outre de manière privilégiée, on recherche pour celle-ci des métaux oxydables de manière à former une couche d'oxyde natif.

Avantageusement, la première sous-couche est réalisée en un métal choisi dans le groupe comprenant l'aluminium, l'étain, l'indium, le plomb, l'argent, le cuivre, le zinc et les alliages à base de ces métaux. Ces matériaux sont avantageusement très plastiques, et peuvent être mise en œuvre dans des processus de gravure bas coût exploitables pour des pas d'interconnexion faibles inférieurs à 10 micromètres, voire même 5 micromètres. Plus particulièrement, la première sous-couche est constituée d'aluminium qui présente également l'avantage d'être un matériau à la fois ductile tout en gardant une dureté constante pour une large plage de températures en raison de sa température de fusion élevée supérieure à 500°C.

L'avantage de la mise en œuvre d'un insert creux réside dans la réduction de la surface d'appui de l'insert sur le plot, et donc de faciliter l'insertion, voire même de permettre une insertion à froid à température ambiante. Du fait de la surface d'appui réduite, la pression surfacique exercée sur la surface des première et seconde couches en appui sur le plot est également augmentée, ce qui facilite la déformation de la première couche, et corollairement la craquelure de la seconde couche. Ceci augmente également l'effet de cisaillement et aide au pelage de la seconde couche en cas de faible adhérence de celle-ci sur la première couche. On remarque que le cylindre est la forme qui optimise ces effets, les inserts creux étant ainsi avantageusement de cette forme.

Selon une variante, la première sous-couche a une ductilité sensiblement égale à celle des plots, ce qui facilite la déformation subie par la première sous-couche lors de l'insertion, et donc facilite également le craquelage de la seconde sous-couche

Selon un mode de réalisation, qui ne fait pas partie de l'objet des revendications, le procédé consiste :
▪ à déposer une couche sacrificielle sur la face de connexion du premier composant ;
▪ à réaliser des ouvertures dans la couche sacrificielle au droit des emplacements souhaités pour les inserts ;
▪ à déposer une première couche métallique au moins dans les ouvertures de manière à réaliser l'âme métallique pour chaque insert ;
▪ à déposer une seconde couche métallique au moins dans les ouvertures de manière à réaliser une couche métallique recouvrant l'âme de chaque insert ; et
▪ à retirer la couche sacrificielle.

Non seulement, ce procédé permet de fabriquer des inserts qui ne sont pas entourés de couronne de métal, mais en outre il permet de réduire le coût de fabrication. En effet, le coût est principalement inhérent au nombre de séquences de fabrication nécessitant un changement de matériel. Notamment, dans le procédé de fabrication décrit en relation avec les figures 3 à 10, on observe une première séquence de fabrication relative à la réalisation des ouvertures **42** (figure 3), une deuxième séquence relative au dépôt du métal constitutif de l'âme **50** des inserts **16** (figure 4), une troisième séquence relative au retrait de la couche sacrificielle **40** (figures 5 à 8), une quatrième séquence relative au dépôt de la couche de métal noble **52** (figure 9) et une cinquième séquence relative au retrait de la couche de métal **52** noble entre les inserts **16** (figure 10). Comme cela sera plus aisément compréhensible à la lecture de ce qui suit, le procédé selon l'invention comporte uniquement trois séquences de fabrication, ce qui représente une réduction importante du coût de fabrication.

L'invention a pour objet un procédé d'hybridation de type face contre face d'un composant microélectronique obtenu selon un procédé du type précité avec un composant microélectronique ayant sur une de ses face des plots conducteurs respectifs de dureté inférieure à la dureté de l'âme métallique des inserts creux, comportant l'insertion à température ambiante des inserts, munis de leur seconde sous couche métallique, dans les plots.

Avantageusement, le pas d'interconnexion entre les microcomposants est inférieur à 10 micromètres.

Selon un mode de réalisation, la pression exercée sur une surface d'appui de chaque insert lors de leur insertion dans les plots est supérieure à 1800 mégapascal, ce qui permet un pelage efficace de la couche d'oxyde.

### BREVE DESCRIPTION DES FIGURES

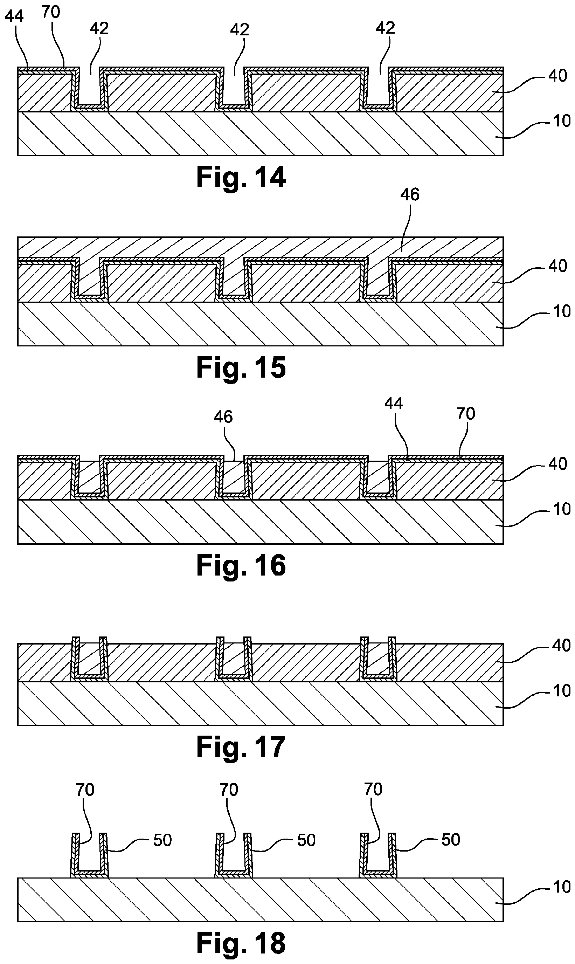

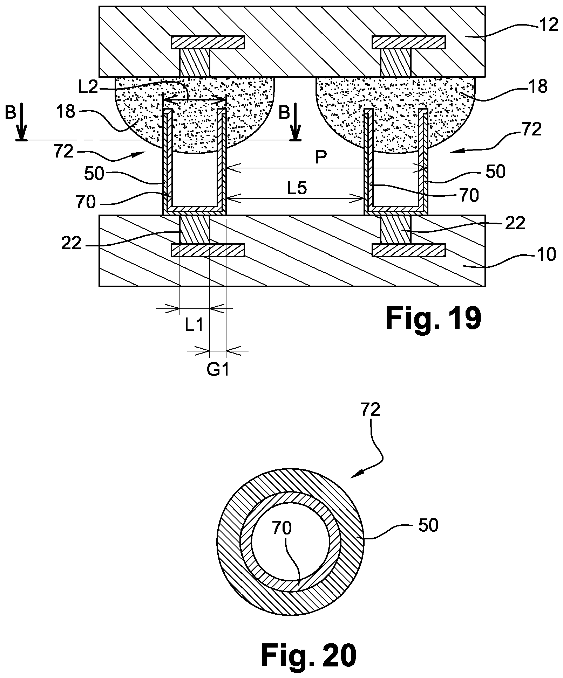

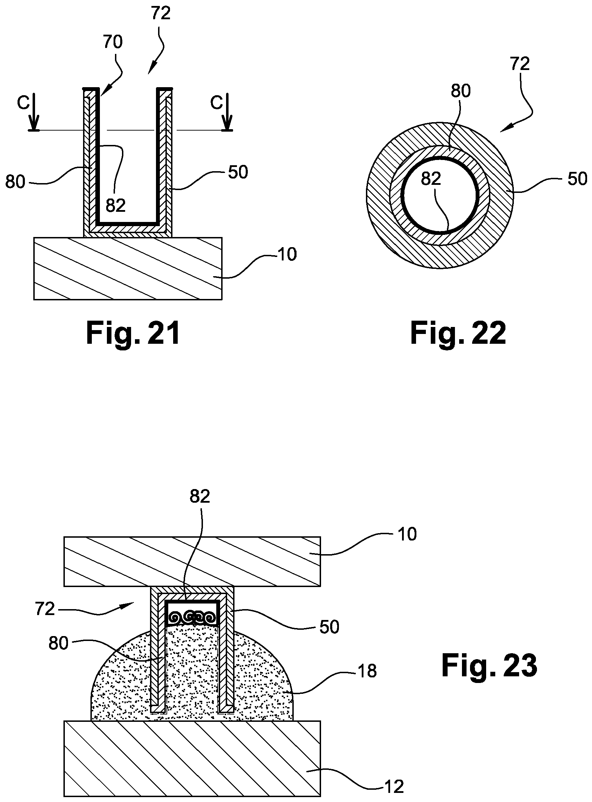

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
▪ les figures 1 et 2 sont des vues schématiques en coupe de l'hybridation d'un premier et d'un second composants microélectroniques par insertion d'inserts dans des plots ;
▪ les 3 à 10 sont des vues schématiques en coupe illustrant un procédé de fabrication d'inserts comportant une couche externe de métal noble ;
▪ la figure 11 est une vue en coupe de deux inserts adjacents fabriqués selon le procédé des figures 3 à 10 et insérés dans des plots respectifs ;
▪ la figure 12 est une vue schématique en coupe d'un insert de la figure 11 selon le plan A-A;
▪ la figure 13 est une vue schématique d'un insert fabriqué selon le procédé des figures 3 à 10 et inséré dans un plot, illustrant les courants électriques dans l'insert ;
▪ les figures 14 à 18 sont des vues schématiques en coupe illustrant un procédé de fabrication d'inserts selon l'invention ;
▪ la figure 19 est une vue en coupe selon une première variante de réalisation de l'invention, de deux inserts adjacents fabriqués selon le procédé des figures 14 à 18 et insérés dans des plots respectifs ;
▪ la figure 20 est une vue schématique en coupe d'un insert de la figure 19 selon le plan B-B ;
▪ la figure 21 est une vue en coupe d'un insert selon une seconde variante de réalisation de l'invention ;
▪ la figure 22 est une vue schématique en coupe de l'insert de la figure 3 selon le plan C-C ;
▪ la figure 23 est une vue schématique en coupe illustrant la pénétration de l'insert de la figure 21 dans un plot ductile

### DESCRIPTION DETAILLEE DE L'INVENTION

Il va à présent être décrit en relation avec les figures 14 à 18 un procédé de fabrication d'inserts pour une hybridation « *flip-chip* » selon l'invention d'un premier et d'un second composants microélectroniques analogue à celle décrite en relation avec les figures 1 et 2.

On notera que les inserts peuvent prendre n'importe quelle forme, bien que les inserts présentant une surface d'appui réduite, comme des cylindres creux par exemple, soient privilégiés pour diminuer la pression nécessaire à leur insertion dans les plots. Dans ce qui suit, il va cependant être décrit des inserts cylindriques et creux de section en forme de U, cette forme constituant un mode de réalisation privilégié. Cependant, on comprendra que les considérations portant sur les matériaux constitutifs des inserts et des plots sont indépendantes de la forme adoptée pour ceux-ci. Par exemple, les inserts peuvent être pleins et/ou de forme triangulaire, carrée, et de manière plus générale polygonale, en forme d'étoile, etc...

Le procédé débute de manière analogue aux étapes de fabrication décrites en relation avec les figures 3 et 4. Le métal **44** constitutif de l'âme **50** des inserts présente une dureté supérieure à celle des plots **18** pour pouvoir y être insérés. A cet effet, l'âme centrale **50** a de préférence un module d'Young supérieur à 1,5 fois le module de Young du matériau des plots **18.**

Avantageusement, le métal **44** constitutif de l'âme centrale **50** est constituée d'un métal dur, comme du nitrure de titane (TiN), du nitrure de tungstène (NiW), du cuivre (Cu), du vanadium (V), du molybdène (Mo), du nickel (Ni), du tungstènate de titane (TiW), du WSi, ou du tungstène (W) par exemple, et les plots **18** sont constitués d'un métal ductile, par exemple de l'aluminium, de l'étain, de l'indium, du plomb, de l'argent, du cuivre, du zinc, ou un alliage de ces métaux.

Le procédé se poursuit par le dépôt pleine plaque d'une couche ou d'un multicouche de métal **70** ayant pour fonction de protéger la surface interne de l'âme central **50** des inserts de l'oxydation, et présentant optionnellement une résistivité électrique inférieure au métal **44,** le métal **44** constitutif de l'âme n'étant pas oxydé à cette étape du procédé. Le dépôt est par exemple un dépôt chimique en phase vapeur ou dépôt CVD réalisé à une température compatible avec les éléments microélectroniques du composant **10,** notamment une température inférieure à 425°C pour un composant **10** mettant en œuvre une technologie CMOS (figure 14).

La couche **70** est de préférence constituée d'aluminium, ce métal présentant l'avantage d'avoir une température de fusion très élevée supérieure à 500°C.

Un retrait de la portion de la couche de métal dur **44** déposée entre les trous **42** est alors effectué, par exemple à l'aide d'une gravure « damascène » ou de « gap fil » bien connue en soi.

Par exemple, une gravure « gap-fil » analogue à celle décrite en relation avec les figures 5 à 8 est mise en œuvre, comportant :
- le dépôt pleine plaque d'une couche de résine fluide **46** (figure 15),
- la gravure uniforme de la couche **46** solidifiée jusqu'à atteindre la surface de la couche métallique **70** (figure 16),
- la gravure de l'empilement de couches métalliques **44, 70** agencé entre les trous **42** (figure 17), et
- le retrait de la résine **46** comprise dans les trous **42,** suivi du retrait de la couche sacrificielle **40** (figure 18).

Le procédé comporte donc trois séquences de fabrication, à savoir une première séquence de fabrication relative à la réalisation des ouvertures **42** (figure 3), une deuxième séquence relative au dépôt des métaux **44** et **70** (figure 14), une troisième séquence relative au retrait de la couche sacrificielle **40** (figures 15 à 18).

Les figures 19 et 20 sont des vues schématiques en coupe illustrant des inserts **72** fabriqués selon le procédé venant d'être décrit. Comme illustré, les inserts **72** sont constitués d'une âme centrale **50,** dont uniquement la surface interne est recouverte d'une couche de protection métallique contre l'oxydation **70.**

Toujours en prenant l'hypothèse simplificatrice de plages de connexion cylindrique **22** alignées avec leurs inserts **16** respectifs, le pas d'interconnexion *P* obtenu grâce à l'invention est égal à la somme de la largeur *L1* de la plage de connexion **22,** du double de la largeur *G1* entre le diamètre externe de l'âme **50** d'un insert **16,** et de la largeur *L5* séparant les diamètres externes des inserts **72** adjacents, à savoir P = L1 + 2G1 + L5.

En reprenant les exemples numériques décrits précédemment, à savoir une valeur minimale de *L1* égale à 3 micromètres, une valeur minimale de *G1* égale à 1 micromètre, et une valeur de *L5* égale à 3 micromètres, il est obtenue un pas d'interconnexion *P* minimum égale à 8 micromètres, soit une densité surfacique d'interconnexions égale à environ 1,625.10⁴ interconnexions/mm².

Selon une première variante, la couche de métal **70** est constituée d'un métal noble, comme de l'or ou du platine par exemple.

Selon une seconde variante, illustrée sur les figures schématiques en coupe 21 et 22, la couche de métal **70** est constituée d'une première sous-couche métallique **80** formée sur l'âme **50** de l'insert **72,** la sous-couche **80** étant elle-même recouverte par une sous-couche de protection **82.**

La première sous-couche métallique **80,** outre sa fonction d'être conductrice de l'électricité et d'adhérer fortement à l'âme centrale **50** de l'insert **72** en raison de l'interface métal-métal qu'elle forme avec l'âme **50,** a pour fonction de se déformer, tout en restant accrochée à l'âme **50,** lors de la pénétration de l'insert dans un plot **18.** Elle présente à cet effet une plasticité supérieure à celle de l'âme **50.** La sous-couche **80** peut ainsi être constituée d'un métal ductile. Notamment, un métal ductile ayant un module d'Young supérieur à 1,5 fois celui du matériau de l'âme **50** présente une plasticité appropriée.

De préférence, la sous-couche **80** présente une ductilité sensiblement égale à celle des plots **18** de manière à permettre la pénétration de l'âme dure **50** sans se casser et obtenir des déformations relatives de la sous-couche **80** et du plot **18** de manière sensiblement égales.

La sous-couche **80** est ainsi avantageusement constituée d'aluminium, d'étain, d'indium, de plomb, d'argent, de cuivre, de zinc ou d'un alliage de ces métaux. Par ailleurs, la sous-couche métallique **80** n'est pas oxydée.

La sous-couche de protection **82** a pour première fonction de protéger la sous-couche métallique **80** de l'oxydation, et pour seconde fonction de libérer au moins une portion de la sous-couche métallique **80** lors de l'insertion de l'insert **72** dans un plot **18** de manière à créer une connexion électrique entre le matériau du plot **18** et l'âme centrale **50.** Pour ce faire, la sous-couche de protection **82** est choisie pour se craqueler sous l'effet de la déformation de la sous-couche métallique **80.** La sous-couche de protection **82** présente ainsi une plasticité inférieure à celle de la sous-couche métallique **80.**

De préférence, la sous-couche de protection **82** est choisie de manière à présenter un seuil de rupture sous des contraintes de déformation très bas, autrement dit est très « cassante ». La sous-couche de protection **82** peut être un film de protection rapporté sur la sous-couche métallique **80,** comme par exemple une résine époxy photosensible ou une couche de polymère tel que du parylène par exemple, ou une couche de métal dur ou une couche d'isolant dur et cassant comme par exemple du SiO₂ ou du SiN.

De préférence, la sous-couche de protection **82** est constituée de l'oxyde natif du métal constitutif de la sous-couche métallique **80,** ce qui présente le triple avantage :
- de disposer d'une sous-couche de protection **82** très fine, de l'ordre de quelques nanomètres,
- d'être dure et cassante, et notamment de plasticité et de ductilités très inférieures à celles du métal **80** lui-même, et
- d'adhérer très faiblement à la sous-couche métallique **80.**

De plus ce mode de réalisation présente l'avantage qu'il n'est pas besoin de prendre des mesures particulières pour éviter l'oxydation des inserts lors de leur stockage, puisqu'on laisse volontairement s'oxyder les inserts **72.**

Comme illustré à la figure 22, lors de la pénétration de l'insert **72** dans le plot **18,** une déformation, même faible de la sous-couche métallique **80,** casse la couche d'oxyde **82** en plaques, et sous l'effet du cisaillement, les plaques d'oxyde natif glissent sur la sous-couche métallique **80** en demeurant en dehors du plot **18.** La couche d'oxyde **82** est ainsi « pelée » lors de l'insertion en mettant à nue la sous-couche métallique **80,** créant ainsi une connexion électrique de qualité, notamment sans oxyde.

Il a été décrit une âme centrale **50** non oxydée sur la totalité de sa surface interne. En variante, seule une portion de la surface interne de l'âme centrale **50** est non oxydée. L'âme centrale **50** est alors recouverte de la couche **70** au moins sur cette portion non oxydée. Dans la seconde variante, la sous-couche recouvre au moins cette portion non oxydée et la sous-couche de protection **82** recouvre au moins la portion de la sous-couche **80,** recouvrant la partie non oxydée de l'âme **50,** cette portion de la sous-couche **80** étant non oxydée.

Comme dit plus haut, les inserts **72** sont de préférence des cylindres creux ayant des surfaces d'appui S (figure 3 et 4) très faibles, de manière à pouvoir réaliser une insertion à froid, sous atmosphère ambiante, c'est-à-dire sous une température ambiante très inférieure à la température de fusion des plots **18,** par exemple une température d'environ 300°K, et sous pression atmosphérique. Outre ceci, des surfaces d'appui très faible ont pour effet d'augmenter les contraintes exercées sur les différentes régions des inserts et donc notamment les forces de déformation et de cisaillement, ce qui facilite la craquelure des la sous-couche de protection **82** ainsi que son pelage dans le cas d'une couche de protection faiblement adhérente à la sous-couche métallique **80.** On se reportera avantageusement au document FR 2 928 033 pour le calcul de la surface d'appui permettant une insertion à froid sous atmosphère ambiante.

De manière avantageuse, la pression exercée sur la surface d'appui S lors de l'insertion d'insert comprenant une première sous-couche **80** en aluminium recouverte d'une couche d'oxyde natif **82** (alumine Al₂O₃) dans des plots **18** en aluminium est supérieure à 1800 mega Pascal. Les inventeurs en en effet observé que pour des valeurs de pression inférieures, les interconnexions formées des inserts **16** dans les plots **18** présentent une résistance électrique importante, ce qui signifie que le pelage de la couche d'oxyde **82** n'est pas complète. Les inventeurs ont par contre observé que pour la configuration d'inserts et de plots précédente des pressions supérieures à 1800 megaPascal (MPa) produisent des interconnexions de bonne qualité, c'est-à-dire présentant une résistance électrique proche de celle de l'aluminium, ce qui signifie que la couche d'oxyde a été pelée de manière quasi complète.

De manière avantageuse, la force d'insertion globale, ou de manière équivalente la pression d'insertion globale, exercée sur les circuits **10** et **12** pour hybrider ceux-ci, par exemple celle exercée sur le circuit **10** tel qu'illustrée par les flèches à la figure 1, et la surface d'appui S des cylindres creux sont donc choisies de manière à obtenir ladite pression minimale.

Par exemple, un cylindre creux d'un diamètre égal à 4µm, avec une épaisseur de paroi égale à 0,2 µm a une surface d'appui S égale à 2,512 µm². Lorsqu'un tel insert subit une force d'insertion de 5mN, la pression exercée sur sa surface d'appui S est égale à 1990 MPa.

Connaissant la force d'insertion globale et le nombre d'interconnexions entre les circuits **10** et **12,** on en déduit donc la force d'insertion unitaire subit par chaque insert **16.** Connaissant la force d'insertion unitaire, on est donc capable d'en déduire une aire maximale d'appui pour obtenir au moins la pression minimale de 1800MPa. Enfin, la surface d'appui S d'un cylindre creux étant donnée par la relation *S* = 2 × *π* × (*R*₂ - *R*₁) × *R*₂, où *R*₂ - *R*₁ est l'épaisseur des parois des inserts **16** et 2 × *R*₂ est le diamètre externe des inserts **16** (figure 4), on en déduit aisément des couples d'épaisseur et de diamètre. Le choix de valeur particulière pour l'épaisseur et le diamètre peut alors être réalisé selon d'autres considérations, notamment des considérations pourtant sur des épaisseurs atteignables en fonction du procédé de fabrication utilisé ou des considérations portant sur la robustesse mécanique des inserts.

## Revendications

1. Procédé d'hybridation de type face contre face d'un premier composant microélectronique (10) muni sur une face de connexion (14) d'inserts conducteurs (72) avec un second composant microélectronique (12) ayant sur une de ses faces (20) des plots conducteurs ductiles respectifs (18), procédé dans lequel
▪ chaque insert (72) du premier composant (10) comprend :
∘ une âme métallique creuse (50) constituée d'un fond disposé sur la face de connexion (14) et d'une paroi latérale faisant saillie dudit fond, définissant une surface interne de l'insert (72), au moins une portion de ladite surface interne étant non oxydée; et
∘ une couche métallique (70) recouvrant sensiblement uniquement la surface interne de l'âme métallique (50) et destinée à être au contact du plot associé à l'insert, la couche métallique (70) comportant une première sous-couche métallique (80) non oxydée sur au moins une portion de sa surface, recouvrant au moins ladite portion non oxydée de la surface interne de l'âme (50), la première sous-couche (80) ayant une plasticité supérieure à celle de l'âme (50), et une seconde sous-couche (82) recouvrant au moins la première sous-couche (80) sur sa portion non oxydée et ayant une plasticité inférieure à celle de la première sous-couche (80) ;
▪ les plots du second composant sont constitués d'un matériau de dureté inférieure à la dureté de l'âme métallique des inserts creux du premier composant; et
▪ la connexion électro-mécanique des premier et second composants micro électroniques (10, 12) consiste en l'insertion, à température ambiante des inserts (16) du premier composant (10), munis de leur seconde sous couche métallique (82), dans le matériau des plots (18) du second composant.

2. Procédé selon la revendication 1, ***caractérisé* en ce que** le pas d'interconnexion entre les microcomposants est inférieur à 10 micromètres.

3. Procédé selon la revendication 1 ou 2, ***caractérisé* en ce que** la première sous-couche (80) est constituée d'un métal oxydable, et **en ce que** seconde sous-couche (82) est réalisée en oxydant la première sous-couche (26) de manière à créer une couche d'oxyde natif du métal constitutif de la première sous-couche ayant une plasticité inférieure à celle de la première sous-couche (80).

4. Procédé selon la revendication 3, ***caractérisé* en ce que** la première sous-couche (80) est constituée d'aluminium, la seconde souche-couche (82) étant un oxyde d'aluminium.

5. Procédé selon la revendication 1, 2, 3 ou 4, ***caractérisé* en ce que** l'âme métallique creuse (50) est constituée d'un métal dur, notamment de nitrure de titane, de nitrure de tungstène, de cuivre, de vanadium, de molybdène, de nickel, de tungstènate de titane, de WSi, et/ou de tungstène.

6. Procédé selon l'une quelconque des revendications précédentes, ***caractérisé* en ce que** la première sous-couche (80) a une ductilité égale à celle des plots (18).

7. Procédé d'hybridation de type face contre face d'un premier composant microélectronique (10) muni sur une face de connexion (14) d'inserts conducteurs (72) avec un second composant microélectronique (12) ayant sur une de ses faces (20) des plots conducteurs ductiles respectifs (18), procédé dans lequel
▪ chaque insert (72) du premier composant (10) comprend :
∘ une âme métallique creuse (50) constituée d'un fond disposé sur la face de connexion (14) et d'une paroi latérale faisant saillie dudit fond, définissant une surface interne de l'insert (72), au moins une portion de ladite surface interne étant non oxydée; et
∘ une couche métallique (70) recouvrant sensiblement uniquement la surface interne de l'âme métallique (50) et destinée à être au contact du plot associé à l'insert, la couche métallique (70) étant constituée d'un métal noble ;
▪ les plots du second composant sont constitués d'un matériau de dureté inférieure à la dureté de l'âme métallique des inserts creux du premier composant; et
▪ la connexion électro-mécanique des premier et second composants micro électroniques (10, 12) consiste en l'insertion, à température ambiante des inserts (16) du premier composant (10) dans le matériau des plots (18) du second composant.

8. Procédé selon la revendication 7, ***caractérisé* en ce que** le pas d'interconnexion entre les microcomposants est inférieur à 10 micromètres.

9. Procédé selon la revendication 7 ou 8, ***caractérisé* en ce que** l'âme métallique creuse (50) est constituée d'un métal dur, notamment de nitrure de titane, de nitrure de tungstène, de cuivre, de vanadium, de molybdène, de nickel, de tungstènate de titane, de WSi, et/ou de tungstène.

## Patentansprüche

1. Hybridisierungsverfahren vom Typ Face-to-Face zum Hybridisieren eines ersten, auf einer Verbindungsfläche (14) mit leitfähigen Einsätzen (72) versehenen mikroelektronischen Komponenten (10) mit einem zweiten mikroelektronischen Komponenten (12), der auf einer seiner Flächen (20) jeweils duktile leitfähige Zapfen (18) aufweist, wobei bei dem Verfahren jeder Einsatz (72) des ersten Komponenten (10) folgendes umfasst:
- einen hohlen Metallkern (50), bestehend aus einem auf der Verbindungsfläche (14) angeordneten Boden und einer auf dem Boden aufgesetzten Seitenwand, die eine Innenfläche des Einsatzes (72) definiert, wobei mindestens ein Teil dieser Innenfläche nicht oxidiert ist; und
- eine Metallschicht (70), die im Wesentlichen nur die Innenfläche des Metallkerns (50) bedeckt und dazu bestimmt ist, mit dem dem Einsatz zugeordneten Zapfen in Kontakt zu stehen, wobei die Metallschicht (70) eine erste nicht oxidierte Metallunterschicht (80) über mindestens einen Teil ihrer Oberfläche umfasst, die zumindest den nicht oxidierten Teil der Innenfläche des Kerns (50) bedeckt, wobei die erste Unterschicht (80) eine höhere Plastizität als der Kern (50) aufweist, und eine zweite Unterschicht (82), die zumindest die erste Unterschicht (80) auf ihrem nicht oxidierten Teil bedeckt und eine geringere Plastizität als die erste Unterschicht (80) aufweist;
- wobei die Zapfen des zweiten Komponenten aus einem Material hergestellt sind, dessen Härte geringer ist als die Härte des Metallkerns der hohlen Einsätze des ersten Komponenten; und
- wobei die elektromechanische Verbindung des ersten und des zweiten mikroelektronischen Komponenten (10, 12) darin besteht, bei Raumtemperatur der mit ihrer zweiten metallischen Unterschicht (82) versehenen Einsätze (16) des ersten Komponenten (10) diese in das Material der Zapfen (18) des zweiten Komponenten einzusetzen.

2. Verfahren gemäß Anspruch 1, **dadurch gekennzeichnet, dass** der Verbindungsabstand zwischen den Mikrokomponenten weniger als 10 Mikrometer beträgt.

3. Verfahren gemäß Anspruch 1 oder 2, **dadurch gekennzeichnet, dass** die erste Unterschicht (80) aus einem oxidierbaren Metall besteht und dass die zweite Unterschicht (82) durch Oxidation der ersten Unterschicht (26) hergestellt wird, um eine native Oxidschicht des die erste Unterschicht bildenden Metalls mit einer geringeren Plastizität als die der ersten Unterschicht (80) zu erzeugen.

4. Verfahren gemäß Anspruch 3, **dadurch gekennzeichnet, dass** die erste Unterschicht (80) aus Aluminium besteht und die zweite Unterschicht (82) ein Aluminiumoxid ist.

5. Verfahren gemäß Anspruch 1, 2, 3 oder 4, **dadurch gekennzeichnet, dass** der hohle Metallkern (50) aus einem Hartmetall, insbesondere Titannitrid, Wolframnitrid, Kupfer, Vanadium, Molybdän, Nickel, Titan-Wolframat, WSi und/oder Wolfram besteht.

6. Verfahren gemäß einem der vorstehenden Ansprüche, **dadurch gekennzeichnet, dass** die erste Unterschicht (80) dieselbe Duktilität wie die der Zapfen (18) besitzt.

7. Hybridisierungsverfahren vom Typ Face-to-Face zum Hybridisieren eines ersten, auf einer Verbindungsfläche (14) mit leitfähigen Einsätzen (72) versehenen mikroelektronischen Komponenten (10) mit einem zweiten mikroelektronischen Komponenten (12), der auf einer seiner Flächen (20) jeweils duktile leitfähige Zapfen (18) aufweist, wobei bei dem Verfahren
- jeder Einsatz (72) des ersten Komponenten (10) folgendes umfasst:
- einen hohlen Metallkern (50), bestehend aus einem auf der Verbindungsfläche (14) angeordneten Boden und einer auf dem Boden aufgesetzten Seitenwand, die eine Innenfläche des Einsatzes (72) definiert, wobei mindestens ein Teil dieser Innenfläche nicht oxidiert ist; und
- eine Metallschicht (70), die im Wesentlichen nur die Innenfläche des Metallkerns (50) bedeckt und dazu bestimmt ist, mit dem dem Einsatz zugeordneten Zapfen in Kontakt zu stehen, wobei die Metallschicht (70) aus einem Edelmetall besteht;
- wobei die Zapfen des zweiten Komponenten aus einem Material hergestellt sind, dessen Härte geringer ist als die Härte des Metallkerns der hohlen Einsätze des ersten Komponenten; und
- wobei die elektromechanische Verbindung des ersten und des zweiten mikroelektronischen Komponenten (10, 12) darin besteht, bei Raumtemperatur der Einsätze (16) des ersten Komponenten (10) in das Material der Zapfen (18) des zweiten Komponenten einzusetzen.

8. Verfahren gemäß Anspruch 7, **dadurch gekennzeichnet, dass** der Verbindungsabstand zwischen den Mikrokomponenten weniger als 10 Mikrometer beträgt.

9. Verfahren gemäß Anspruch 7 oder 8, **dadurch gekennzeichnet, dass** der hohle Metallkern (50) aus einem Hartmetall, insbesondere Titannitrid, Wolframnitrid, Kupfer, Vanadium, Molybdän, Nickel, Titan-Wolframat, WSi und/oder Wolfram besteht.

## Claims

1. A method of face-to-face type hybridization of a first microelectronic component (10) provided on one connection surface (14) with conductive inserts (72) with a second microelectronic component (12) provided on one of its face (20) respective ductile conductive pads (18), method in which:
▪ each insert (72) of the first component (10) comprises:
∘ a hollow metal core (50) formed of a bottom arranged on the connection surface (14) and of a lateral wall protruding from said bottom, defining an internal surface of the insert (72), at least a portion of said internal surface being non-oxidized; and
∘ a metal layer (70) substantially only covering the internal surface of the metal core (50) and intended to be in contact with the pad associated with the insert, the metal layer (70) comprising a first metal sub-layer (80) non-oxidized over at least a portion of its surface, covering at least said non-oxidized portion of the internal surface of the core (50), the first sub-layer (80) having a greater plasticity than the core (50), and a second sub-layer (82) covering at least the first sub-layer (80) over its non-oxidized portion and having a lower plasticity than the first sub-layer (80) ;
▪ the pads of the second component are made of a material having a lower hardness than that of the metal core of the hollow inserts of the first component;
▪ the electro-mechanical connection of the first and the second microelectronic components (10, 12) consisting in inserting at ambient temperature the inserts (16) of the first component (10), provided with their second metal sub-layer (82), into the pads (18) of the second component.

2. The method of claim 1, **characterized in that** the interconnect pitch between microcomponents is smaller than 10 micrometers.

3. The method of claim 1 or 2, **characterized in that** the first sub-layer (80) is made of an oxidizable metal and **in that** the second sub-layer (82) is made by oxidizing the first sub-layer (26) to create a layer of native oxide of the metal forming the first sub-layer having a plasticity lower than that of the first sub-layer (80).

4. The method of claim 3, **characterized in that** the first sub-layer (80) is made of aluminum, the second sub-layer (82) being an aluminum oxide.

5. The method of claim 1, 2, 3 or 4, **characterized in that** the hollow metal core (50) is made of a hard metal, particularly of titanium nitride, of tungsten nitride, of copper, of vanadium, of molybdenum, of nickel, of titanium tungstenate, of WSi, and/or of tungsten.

6. The method of any of the foregoing claims, **characterized in that** the first sub-layer (80) has a ductility equal to that of the pads (18).

7. A method of face-to-face type hybridization of a microelectronic component (10) provided on one connection surface (14) with conductive inserts (72) with a second microelectronic component (12) provided on one of its face (20) respective ductile conductive pads (18), method in which:
▪ each insert (72) of the first component (10) comprises:
∘ a hollow metal core (50) formed of a bottom arranged on the connection surface (14) and of a lateral wall protruding from said bottom, defining an internal surface of the insert (72), at least a portion of said internal surface being non-oxidized; and
∘ a metal layer (70) substantially only covering the internal surface of the metal core (50) and intended to be in contact with the pad associated with the insert, the metal layer (70) being made of noble metal;
▪ the pads of the second component are made of a material having a lower hardness than that of the metal core of the hollow inserts of the first component;
▪ the electro-mechanical connection of the first and the second microelectronic components (10, 12) consisting in inserting at ambient temperature the inserts (16) of the first component (10) into the pads (18) of the second component.

8. The method of claim 7, **characterized in that** the interconnect pitch between the microcomponents is smaller than 10 micrometers.

9. The method of claim 7 or 8, **characterized in that** the hollow metal core (50) is made of a hard metal, particularly of titanium nitride, of tungsten nitride, of copper, of vanadium, of molybdenum, of nickel, of titanium tungstenate, of WSi, and/or of tungsten.
